# FASCICULE DE BREVET EUROPEEN

(11) **EP 2 526 705 B1**
(45) Date de publication et mention de la délivrance du brevet: **17.07.2019**
(21) Numéro de dépôt: 11705020.3
(22) Date de dépôt: 14.01.2011
(51) Int. Cl.: H04R 7/18, H04R 9/06, H04R 31/00, H04R 9/10, B81B 3/00, H04R 7/04, H04R 9/04

(54) **STRUCTURE DE HAUT-PARLEUR ÉLECTRODYNAMIQUE À TECHNOLOGIE MEMS**
ELEKTRODYNAMISCHE LAUTSPRECHERSTRUKTUR MIT MEMS-TECHNOLOGIE
ELECTRODYNAMIC SPEAKER STRUCTURE HAVING MEMS TECHNOLOGY

(30) Priorité: 19.01.2010 FR 1050330
(43) Date de publication de la demande: 28.11.2012
(73) Titulaire: Université du Maine, 72017 Le Mans (FR); Université Paris-Sud, 91405 Orsay Cedex (FR)
(72) Inventeur: LEMARQUAND, Guy, 46100 Beduer (FR); LEMARQUAND, Valérie, 46100 Beduer (FR); LEFEUVRE, Elie, Marie, F-93100 Montreuil (FR); WOYTASIK, Marion, Alexandra, Laurence, F-94230 Cachan (FR); MOULIN, Johan, F-92160 Antony (FR); PARRAIN, Fabien, Jean, François, F-91540 Echarcon (FR)
(74) Mandataire: Lavoix
(86) Numéro de dépôt international: PCT/FR2011/050070
(87) Numéro de publication internationale: WO 2011/089345

(56) Documents cités:
- WO-A1-2007/020925
- WO-A1-2008/011466
- US-A- 1 708 938
- US-A1- 2008 123 242
- SANG-SOO JE ET AL: "A Compact and Low-Cost MEMS Loudspeaker for Digital Hearing Aids", IEEE TRANSACTIONS ON BIOMEDICAL CIRCUITS AND SYSTEMS, IEEE, US LNKD- DOI:10.1109/TBCAS.2009.2026429, vol. 3, no. 5, 1 octobre 2009 (2009-10-01) , pages 348-358, XP011277383, ISSN: 1932-4545 cité dans la demande
- YU WEN HUANG ET AL: "Synthesis and device fabrication of Cu-Ni nanocomposite for low power magnetic microactuation", 7TH IEEE CONFERENCE ON NANOTECHNOLOGY, 2007 : IEEE-NANO 2007 ; HONG KONG, CHINA, 2 - 5 AUG. 2007, PISCATAWAY, NJ : IEEE SERVICE CENTER, PISCATAWAY, NJ, USA, 2 août 2007 (2007-08-02), pages 899-902, XP031307912, ISBN: 978-1-4244-0607-4

## Description

La présente invention concerne une structure de haut-parleur électrodynamique à technologie MEMS.

Plus particulièrement l'invention concerne une telle structure qui comporte des moyens formant stator, des moyens formant diaphragme et des moyens élastiquement déformables, de liaison de ces moyens.

On connaît déjà dans l'état de la technique des structures de haut-parleur de ce type comme celle décrite par exemple dans le document IEEE « Transactions on Biomédical Circuits and Systems », volume 3, No. 5, Octobre 2009, pour «A Compact and Low-Cost MEMS Loudspeaker for Digital Hearing Aids », de Sang-Soo Je et al.

Le document WO2007/020925-A1 décrit une structure de haut-parleur électrodynamique.

Le document US2008/123242-A1 décrit un transducteur capacitif qui est un microphone miniature utilisé dans divers dispositifs tels que des téléphones mobiles.

Dans le document IEEE « Transactions on Biomédical Circuits and Systems », volume 3, No. 5, Octobre 2009, pour «A Compact and Low-Cost MEMS Loudspeaker for Digital Hearing Aids », de Sang-Soo Je et al., les moyens formant diaphragme se présentent sous la forme d'une membrane en polyimide associée à des moyens formant stator réalisés sur la base d'une pastille de silicium.

Cette structure de moyens formant diaphragme présente cependant un certain nombre d'inconvénients notamment au niveau de sa complexité de réalisation, de sa limitation en puissance et de son rendement.

Le but de l'invention est donc de résoudre ces problèmes.

A cet effet l'invention à pour objet une structure de haut-parleur électrodynamique selon la revendication 1.

Selon d'autres aspects de l'invention, la structure de haut-parleur comprend l'une ou plusieurs des caractéristiques des revendications 2 à 14.

L'invention sera mieux comprise à l'aide de la description qui va suivre donnée uniquement à titre d'exemple et faite en se référant aux dessins annexés, sur lesquels :
- la figure 1 représente une vue en perspective avec une portion arrachée d'une structure de haut-parleur selon l'invention,
- la figure 2 représente une vue en perspective à échelle agrandie d'une portion de cette structure,
- les figures 3 et 4 représentent des vues en perspective de la face arrière d'une telle structure,
- la figure 5 illustre l'usinage d'une pastille de silicium monocristallin pour obtenir une structure selon l'invention,
- les figures 6 et 7 représentent des vues de derrière de différentes variantes de réalisation d'une structure selon l'invention, et
- les figures 8 à 11 représentent des vues en perspective illustrant différentes variantes de réalisation d'une structure de haut-parleur selon l'invention.

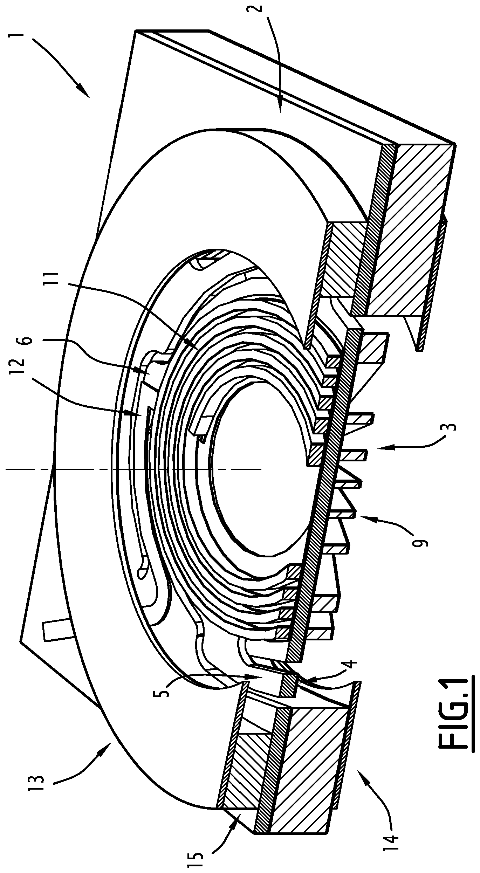

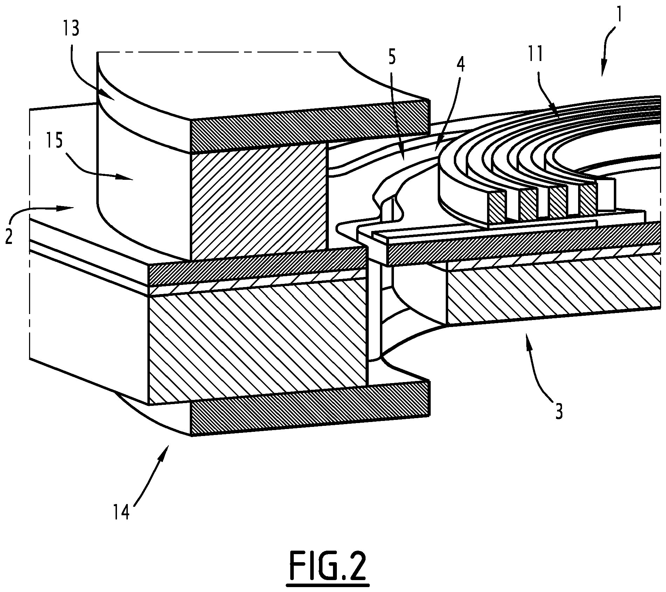

On a en effet illustré sur ces figures et en particulier sur les figures 1 et 2, une structure de haut-parleur électrodynamique à technologie MEMS qui est désignée par la référence générale 1.

De façon générale, une telle structure comporte des moyens formant stator désignés par la référence générale 2, des moyens formant diaphragme désignés par la référence générale 3 et des moyens élastiquement déformables, de liaison de ces moyens, ces moyens élastiquement déformables de liaison étant désignés par la référence générale 4.

En fait et comme cela est illustré, les moyens formant stator, les moyens formant membrane et les moyens de liaison sont formés d'une seule pièce par micro-structuration/usinage d'une pastille de silicium par exemple monocristallin, cette pastille de silicium étant par exemple à base de technologie SOI pour « Silicium On Isolant », comme cela est illustré.

Du silicium polycristallin peut également être envisagé.

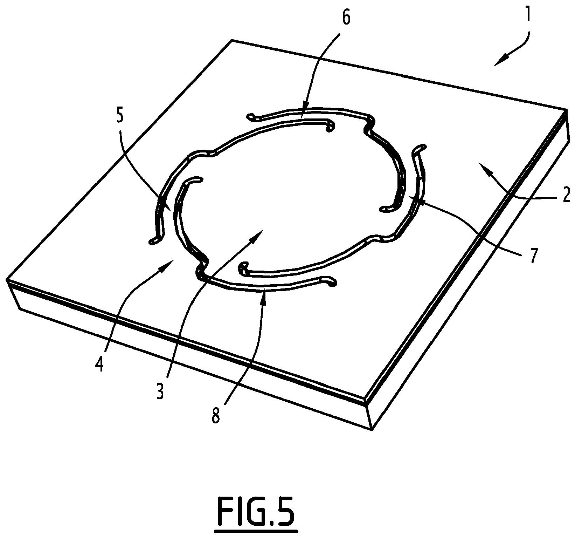

Comme on peut le voir sur les différentes figures 1 à 5 et de façon plus claire sur la figure 5, les moyens de liaison désignés par la référence 4 comprennent en fait des bras de liaison régulièrement répartis entre les moyens formant stator 2 et les moyens formant diaphragme 3.

Ces bras peuvent par exemple être au nombre de quatre comme cela est illustré sur la figure 5.

Il va de soi bien entendu qu'un autre nombre et des formes différentes de bras peuvent être envisagés comme cela sera décrit plus en détail par la suite.

Sur cette figure 5, les différents bras sont désignés par les références 5, 6, 7 et 8 respectivement.

Comme cela est également illustré sur ces figures, au moins l'une des faces comme par exemple la face arrière des moyens formant diaphragme 3 comporte des moyens de rigidification de ceux-ci.

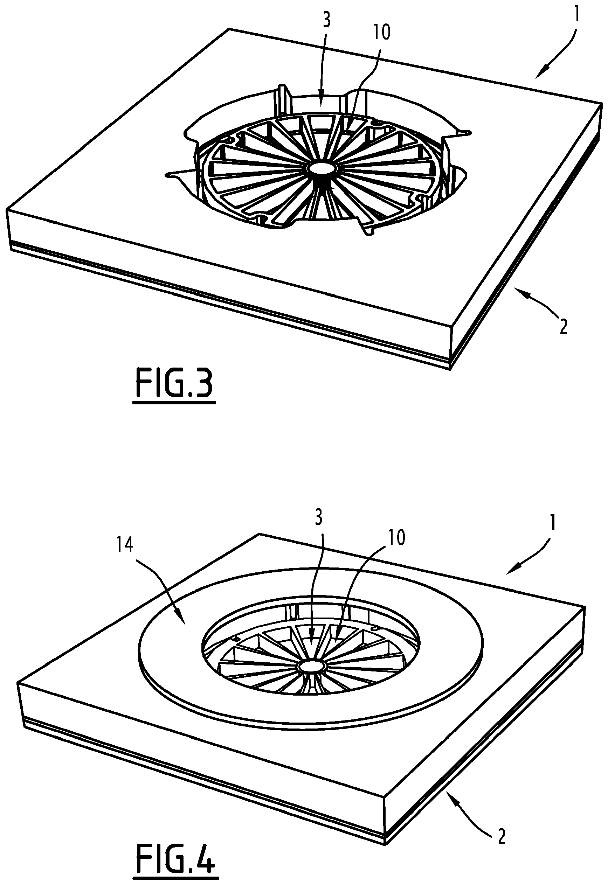

Ces moyens de rigidification sont désignés par la référence générale 9 sur ces figures et ils sont formés par exemple comme cela est visible plus clairement sur les figures 3 et 4, par des nervures de rigidification de préférence radiales dont l'une est par exemple désignée par la référence générale 10.

En fait, cette rigidification des moyens formant diaphragme 3 peut être obtenue par d'autres moyens comme par exemple en prévoyant une épaisseur croissante de ces moyens formant diaphragme, du centre vers leur périphérie.

L'autre face par exemple de ces moyens formant diaphragme 3 comporte des moyens en forme de bobine désignés par la référence générale 11 sur les figures 1 et 2.

Ces moyens en forme de bobine 11 comportent des portions de raccordement électriques portées par les moyens de liaison tels que par exemple la portion désignée par la référence générale 12 sur la figure 1, cette portion étant par exemple portée par le bras de liaison 6.

Ces moyens en forme de bobine 11 peuvent par exemple être réalisés en cuivre mais il va de soi bien entendu que d'autres modes de réalisation peuvent être envisagés.

Enfin au moins l'une des faces de moyens formant stator comprend des moyens en matériau magnétique dur qui se présentent par exemple sous la forme d'un anneau disposé autour des moyens formant diaphragme 3.

Ces moyens en matériau magnétique dur peuvent être réalisés dans un alliage de Samarium-Cobalt ou de Fer-Néodyme-Bore ou autre.

Dans l'exemple de réalisation illustré sur les figures 1 et 2, les deux faces des moyens formant stator comprennent de tels anneaux, ces anneaux étant désignés par les références générales 13 et 14 respectivement.

Ces anneaux sont alors disposés de part et d'autre de la pastille SOI, une entretoise par exemple 15 pouvant être associée à l'anneau 13 de manière à ce que ces anneaux soient disposés symétriquement de part et d'autre de cette pastille.

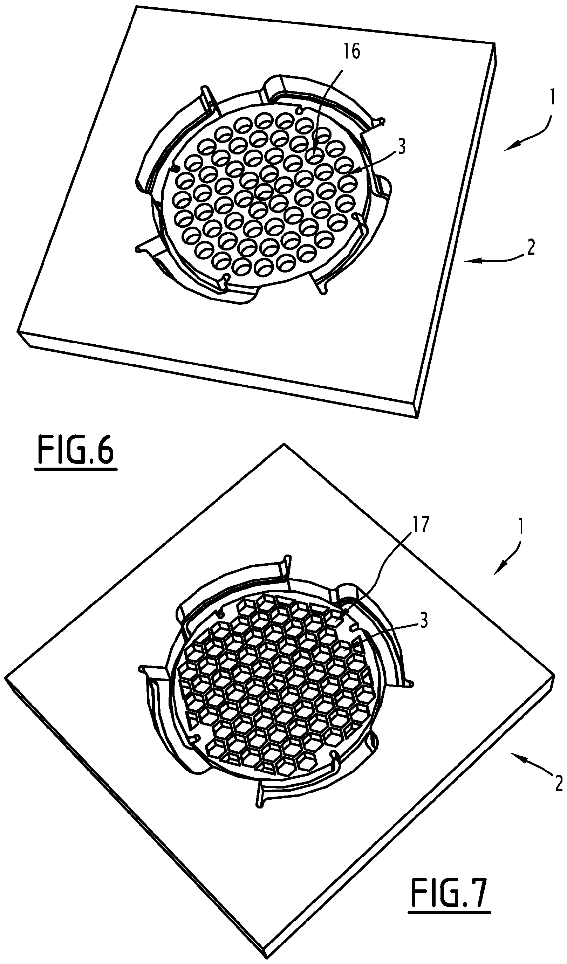

On notera également que, comme cela est illustré sur les figures 6 et 7, au moins l'une des faces des moyens formant diaphragme 3 peut comporter des perçages borgnes tels que par exemple le perçage désigné par la référence générale 16 sur la figure 6 ou le perçage 17 sur la figure 7, ces perçages pouvant présenter des formes diverses.

En fait, ces perçages sont destinés à permettre un allègement de ces moyens formant diaphragme.

Enfin, on notera que la masse des moyens en forme de bobine est égale ou à peu près égale à la masse des moyens formant diaphragme pour optimiser le rendement de cette structure.

On conçoit alors que cette structure de haut-parleur est réalisée de façon collective sur un substrat en silicium. Plusieurs centaines de ces structures peuvent être fabriquées simultanément sur une pastille « WAFER », c'est-à-dire un disque circulaire de silicium traditionnellement utilisé pour la réalisation des composants électroniques semiconducteurs.

Les moyens formant diaphragme sont formés par une surface plane circulaire suspendue par des bras de liaison aux moyens formant stator.

Les différentes formes sont « micro-structurées/usinées » sur le substrat.

Le silicium donne d'une part une grande rigidité à la face parlante, c'est-à-dire la face mobile émettant l'onde sonore, et permet d'autre part une déformation des bras de liaison, sans subir de fatigue mécanique.

Les moyens en forme de bobine sont déposés « en spirale » sur la face mobile, les liaisons électriques se faisant par les bras de liaison.

Un anneau de matériau magnétique dur fixé ou déposé sur les moyens formant stator crée un champ magnétique radial.

L'ensemble réalise un circuit magnétique sans fer et permet une grande qualité acoustique.

Tout ou partie du traitement électrique et de l'amplification du signal pour l'alimentation de cette structure de haut-parleur peut être réalisé sur la même puce de silicium, ce qui permet notamment un pilotage en courant du bobinage mobile.

La réalisation de la partie mobile, diaphragme et bras de liaison, est faite à l'aide de techniques d'usinage du silicium déjà mises en oeuvre pour la réalisation de micro-capteurs de type accéléromètre par exemple.

Le diaphragme est un disque de silicium de diamètre compris entre 5 et 15 millimètres et d'épaisseur de 20 à 400 microns par exemple.

Dans le cas d'un diaphragme épais, ce dernier est allégé par des perçages non débouchants. Cet allègement peut représenter jusqu'à 90 % de la masse initiale. La masse mobile est un critère prépondérant pour le rendement. La partie mobile doit être la plus légère possible, mais la surface émissive c'est-à-dire le diaphragme, doit être la plus rigide possible.

De façon préférentielle, le premier mode propre de déformation de la face parlante doit être de fréquence supérieure à la fréquence la plus aigue de la bande passante de la structure.

Les bras de liaison sont usinés pour permettre le mouvement et le débattement souhaités du diaphragme.

La largeur de l'usinage de l'espace entre les organes est suffisamment petite pour limiter les fuites acoustiques entre face avant et face arrière de la structure.

Les moyens en forme de bobine sont déposés par exemple en cuivre sur l'une des faces du diaphragme selon un procédé connu. La continuité électrique vers la partie mobile est obtenue à l'aide de pistes déposées sur les bras de liaison. L'extrémité centrale de ces moyens en forme de bobine rejoint un bras par la face opposée du diaphragme, en utilisant une technique connue des composants électroniques.

Ces bras de liaison peuvent avoir une épaisseur inférieure à celle du diaphragme, afin de les rendre plus souples.

Le mouvement de la partie mobile doit donc être une image fidèle du signal électrique qui alimente cette bobine et ce signal est amplifié afin de lui conférer la puissance nécessaire pour mettre le diaphragme en mouvement.

Pour obtenir une puissance acoustique donnée, il faut qu'un volume d'air donné soit mis en mouvement et donc que le diaphragme se déplace de façon suffisamment importante.

Les dimensionnements électriques et mécaniques sont ainsi faits dans ce but, afin d'obtenir une source acoustique de qualité supérieure à celle obtenue avec les systèmes de l'état de la technique et permettre une reproduction fidèle de musique notamment, y compris dans les basses fréquences, ce qui n'est pas le cas aujourd'hui.

Une telle structure trouve de nombreuses applications en raison des tensions considérées et des autonomies requises, notamment dans les téléphones, baladeurs, lecteurs de musique divers, etc.

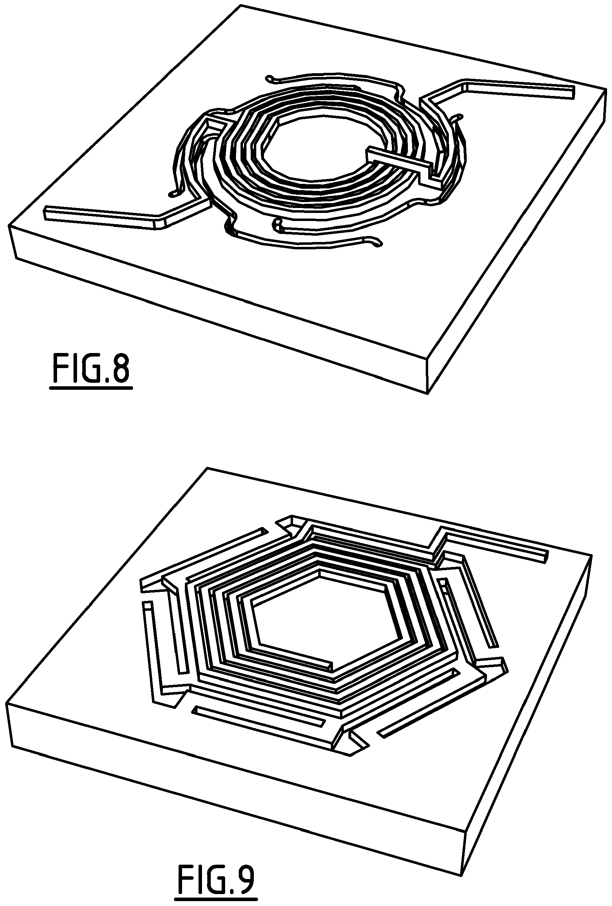

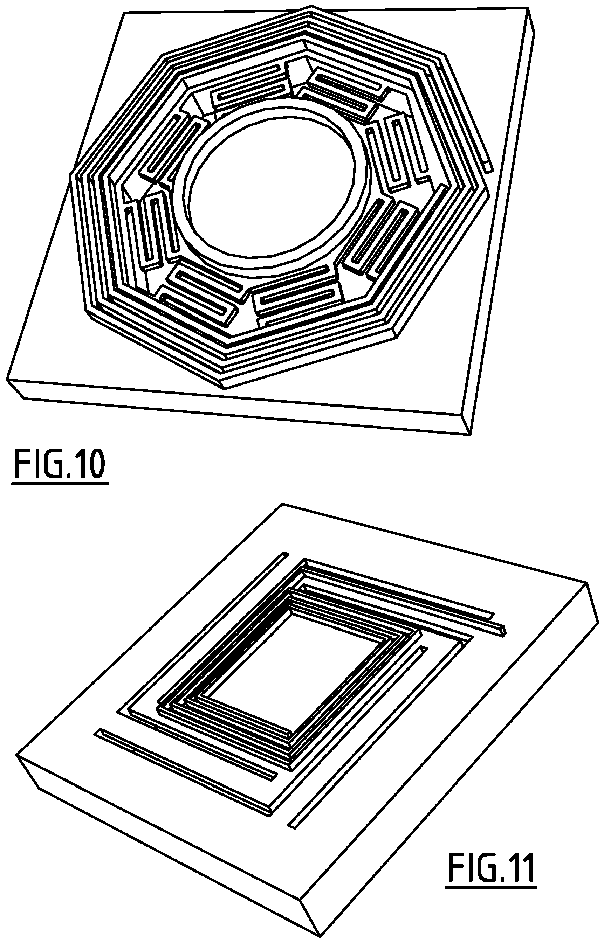

Il va de soi bien entendu que différents modes de réalisation peuvent être envisagés comme cela est illustré sur les figures 8 à 11, différentes formes de moyens formant stator, de moyens formant diaphragme, bobine et bras pouvant être envisagées.

## Revendications

1. Structure de haut-parleur électrodynamique à technologie MEMS, comportant des moyens formant stator (2), des moyens formant diaphragme (3), dans laquelle au moins l'une des faces des moyens formant diaphragme (3) comprend des moyens en forme de bobine (11), **caractérisée en ce qu'**elle comporte des moyens élastiquement déformables (4), de liaison des moyens formant stator (2) et des moyens formant diaphragme (3), et **en ce que** les moyens formant stator (2), les moyens formant diaphragme (3) et les moyens de liaison (4) sont formés d'une seule pièce par usinage d'une pastille de silicium, la masse des moyens en forme de bobine (11) étant égale ou à peu près égale à la masse des moyens formant diaphragme (3).

2. Structure de haut-parleur électrodynamique selon la revendication 1, **caractérisée en ce que** les moyens de liaison (4) comprennent des bras de liaison (5, 6, 7, 8) régulièrement répartis entre les moyens formant stator (2) et les moyens formant diaphragme (3).

3. Structure de haut-parleur électrodynamique selon l'une quelconque des revendications précédentes, **caractérisée en ce qu'**au moins l'une des faces des moyens formant diaphragme (3) comporte des moyens de rigidification (9, 10) de ceux-ci.

4. Structure de haut-parleur électrodynamique selon la revendication 3, **caractérisée en ce que** les moyens de rigidification comprennent des nervures (10).

5. Structure de haut-parleur électrodynamique selon la revendication 4, **caractérisée en ce que** les moyens formant diaphragme (3) sont formés par une surface circulaire et **en ce que** les moyens de rigidification comprennent des nervures radiales (10).

6. Structure de haut-parleur électrodynamique selon l'une quelconque des revendications précédentes, **caractérisée en ce que** les moyens formant diaphragme (3) présentent une épaisseur croissante vers leur périphérie.

7. Structure de haut-parleur électrodynamique selon la revendication 1, **caractérisée en ce que** les moyens en forme de bobine (11) comportent des portions de raccordement électriques (12) portées par les moyens de liaison (4).

8. Structure de haut-parleur électrodynamique selon la revendication 1, **caractérisée en ce que** les moyens en forme de bobine (11) sont réalisés en cuivre.

9. Structure de haut-parleur électrodynamique selon l'une quelconque des revendications précédentes, **caractérisée en ce qu'**au moins l'une des faces des moyens formant stator (2) comprend des moyens en matériau magnétique dur (13, 14).

10. Structure de haut-parleur électrodynamique selon la revendication 9, **caractérisé en ce que** les moyens en matériau magnétique dur se présentent sous la forme d'un anneau (13, 14) disposé autour des moyens formant diaphragme (3).

11. Structure de haut-parleur électrodynamique selon la revendication 9 ou 10, **caractérisé en ce que** les moyens en matériau magnétique dur (13, 14) sont réalisés dans un alliage de Samarium-Cobalt ou de Fer-Néodyme-Bore.

12. Structure de haut-parleur électrodynamique selon l'une quelconque des revendications précédentes, **caractérisée en ce qu'**au moins l'une des faces des moyens formant diaphragme comprend des perçages borgnes (16, 17).

13. Structure de haut-parleur électrodynamique selon l'une quelconque des revendications précédentes, **caractérisée en ce que** la pastille de silicium dans laquelle sont usinés les différents moyens de la structure, est à base de technologie SOI.

14. Structure de haut-parleur électrodynamique selon l'une quelconque des revendications précédentes, **caractérisée en ce que** la pastille est en silicium monocristallin.

## Patentansprüche

1. Struktur eines elektrodynamischen Lautsprechers der Technologie MEMS, aufweisend statorbildende Mittel (2), membranbildende Mittel (3), wobei mindestens eine der Seiten der membranbildenden Mittel (3) spulenförmige Mittel (11) aufweist, **gekennzeichnet dadurch, dass** sie elastisch verformbare Mittel (4) zum Verbinden von den statorbildenden Mitteln (2) und den membranbildenden Mitteln (3) aufweist, und dadurch, dass die statorbildenden Mittel (2), die membranbildenden Mittel (3) und die Mittel zum Verbinden (4) aus einem einzigen Stück durch Bearbeitung einer Siliziumscheibe ausgebildet sind, wobei die Masse der spulenförmigen Mittel (11) gleich oder ungefähr gleich der Masse der membranbildenden Mittel (3) ist.

2. Struktur eines elektrodynamischen Lautsprechers gemäß dem Anspruch 1, **gekennzeichnet dadurch, dass** die Mittel zum Verbinden (4) Verbindungsarme (5, 6, 7, 8), welche regelmäßig zwischen den statorbildenden Mitteln (2) und den membranbildenden Mitteln (3) verteilt sind, aufweisen.

3. Struktur eines elektrodynamischen Lautsprechers gemäß irgendeinem der vorherigen Ansprüche, **gekennzeichnet dadurch, dass** mindestens eine der Seiten der membranbildenden Mittel (3) Mittel zur Aussteifung (9, 10) von diesen aufweist.

4. Struktur eines elektrodynamischen Lautsprechers gemäß dem Anspruch 3, **gekennzeichnet dadurch, dass** die Mittel zur Aussteifung Rippen (10) aufweisen.

5. Struktur eines elektrodynamischen Lautsprechers gemäß dem Anspruch 4, **gekennzeichnet dadurch, dass** die membranbildenden Mittel (3) durch eine kreisförmige Fläche ausgebildet sind, und dass die Mittel zur Aussteifung radiale Rippen (10) aufweisen.

6. Struktur eines elektrodynamischen Lautsprechers gemäß irgendeinem der vorherigen Ansprüche, **gekennzeichnet dadurch, dass** die membranbildenden Mittel (3) eine in Richtung zu ihrem Rand zunehmende Dicke aufweisen.

7. Struktur eines elektrodynamischen Lautsprechers gemäß dem Anspruch 1, **gekennzeichnet dadurch, dass** die spulenförmigen Mittel (11) elektrische Anschlussabschnitte (12), welche durch die Mittel zur Verbindung (4) getragen werden, aufweisen.

8. Struktur eines elektrodynamischen Lautsprechers gemäß dem Anspruch 1, **gekennzeichnet dadurch, dass** die spulenförmigen Mittel (11) aus Kupfer gefertigt sind.

9. Struktur eines elektrodynamischen Lautsprechers gemäß irgendeinem der vorherigen Ansprüche, **gekennzeichnet dadurch, dass** mindestens eine der Seiten der statorbildenden Mittel (2) Mittel aus hartmagnetischen Material (13, 14) aufweist.

10. Struktur eines elektrodynamischen Lautsprechers gemäß dem Anspruch 9, **gekennzeichnet dadurch, dass** die Mittel aus hartmagnetischen Material sich in Form eines Rings (13, 14), welcher um die membranbildenden Mittel (3) herum angeordnet ist, darstellen.

11. Struktur eines elektrodynamischen Lautsprechers gemäß dem Anspruch 9 oder 10, **gekennzeichnet dadurch, dass** die Mittel aus hartmagnetischen Material (13, 14) aus einer Samarium-Kobalt-Legierung oder Neodym-Eisen-Bor-Legierung gefertigt sind.

12. Struktur eines elektrodynamischen Lautsprechers gemäß irgendeinem der vorherigen Ansprüche, **gekennzeichnet dadurch, dass** mindestens eine der Seiten der membranbildenden Mittel Sackbohrungen (16, 17) aufweist.

13. Struktur eines elektrodynamischen Lautsprechers gemäß irgendeinem der vorherigen Ansprüche, **gekennzeichnet dadurch, dass** die Siliziumscheibe, in welche die unterschiedlichen Mittel der Struktur eingearbeitet sind, auf Basis der SOI-Technologie ist.

14. Struktur eines elektrodynamischen Lautsprechers gemäß irgendeinem der vorherigen Ansprüche, **gekennzeichnet dadurch, dass** die Scheibe aus einem monokristallinen Silizium ist.

## Claims

1. An electrodynamic speaker structure having MEMS technology, comprising a stator-forming means (2), diaphragm-forming means (3) wherein at least one of the surfaces of the diaphragm-forming means (3) includes a coil-forming means (11), **characterized in that** it comprises resiliently shape-changing means (4) for connecting the stator-forming means (2) and the diaphragm-forming means (3) and **in that** the stator-forming means (2), diaphragm-forming means (3), and connecting means (4) are made of a single part by machining a silicon chip, the mass of the coil-forming means (11) being equal or approximately equal to the mass of the diaphragm-forming means (3).

2. The electrodynamic speaker structure according to claim 1, **characterized in that** the connecting means (4) include connecting arms (5, 6, 7, 8) regularly distributed between the stator-forming means (2) and the diaphragm-forming means (3).

3. The electrodynamic speaker structure according to any one of the preceding claims, **characterized in that** at least one of the surfaces of the diaphragm-forming means (3) comprises stiffening means (9, 10) thereof.

4. The electrodynamic speaker structure according to claim 3, **characterized in that** the stiffening means includes ribs (10).

5. The electrodynamic speaker structure according to claim 4, **characterized in that** the diaphragm-forming means (3) are formed by a circular surface and **in that** the stiffening means includes radial ribs (10).

6. The electrodynamic speaker structure according to any one of the preceding claims, **characterized in that** the diaphragm-forming means (3) has a thickness increasing toward the periphery thereof.

7. The electrodynamic speaker structure according to claim 1, **characterized in that** the coil-forming means (11) comprises electrical connecting portions (12) supported by the connecting means (4).

8. The electrodynamic speaker structure according to claim 1, **characterized in that** the coil-forming means (11) is made from copper.

9. The electrodynamic speaker structure according to any one of the preceding claims, **characterized in that** at least one of the surfaces of the stator-forming means (2) includes a means made from a hard magnetic material (13, 14).

10. The electrodynamic speaker structure according to claim 9, **characterized in that** the means made from the hard magnetic material assumes the form of a ring (13, 14) arranged around the diaphragm-forming means (3).

11. The electrodynamic speaker structure according to claim 9 or 10, **characterized in that** the means made from a hard magnetic material (13, 14) is made from a Samarium-Cobalt or Iron-Neodyme-Boron alloy.

12. The electrodynamic speaker structure according to any one of the preceding claims, **characterized in that** at least one of the surfaces of the diaphragm-forming means includes blind piercings (16, 17).

13. The electrodynamic speaker structure according to any one of the preceding claims, **characterized in that** the silicon chip in which the different means of the structure are machined is based on SOI technology.

14. The electrodynamic speaker structure according to any one of the preceding claims, **characterized in that** the chip is made from monocrystalline silicon.
